# EUROPÄISCHE PATENTANMELDUNG

(11) **EP 1 170 751 A1**
(43) Veröffentlichungstag der Anmeldung: **09.01.2002**
(21) Anmeldenummer: 01114034.0
(22) Anmeldetag: 08.06.2001
(51) Int. Cl.: G11C 11/16, G11C 11/15

(54) **Verfahren zur Verhinderung von Elektromigration in einem MRAM**

(30) Priorität: 03.07.2000 DE 10032278
(71) Anmelder: Infineon Technologies AG, 81669 München (DE)
(72) Erfinder: Poechmueller, Peter, Dr., 81739 München (DE)
(74) Vertreter: Müller . Hoffmann & Partner Patentanwälte

(57) **Zusammenfassung**

Die Erfindung betrifft ein Verfahren zur Verhinderung von Elektromigration in einem MRAM, bei dem nach einem Programmierschritt ein die Elektromigration kompensierendes Signal entgegengesetzter Polarität den Wort- und Bitleitungen so zugeführt wird, daß keine Programmierung in den Speicherzellen eintritt.

## Beschreibung

Die vorliegende Erfindung betrifft ein Verfahren zur Verhinderung von Elektromigration in einem MRAM (Magnetic Random Access Memory) aus Wortleitungen, die Wortleitungen kreuzenden Bitleitungen und an den Kreuzungspunkten zwischen den Wortleitungen und den Bitleitungen vorgesehenen Widerständen, deren Widerstandswert durch ein Magnetfeld derart beeinflußbar ist, daß dieser zwei logischen Zuständen "0" oder "1" zuzuordnen ist, indem in einem Programmierschritt durch die zu einem ausgewählten Widerstand gehörenden Wort- und Bitleitungen gleichzeitig jeweils ein zusammen das Magnetfeld erzeugendes Gleichstromsignal geschickt wird.

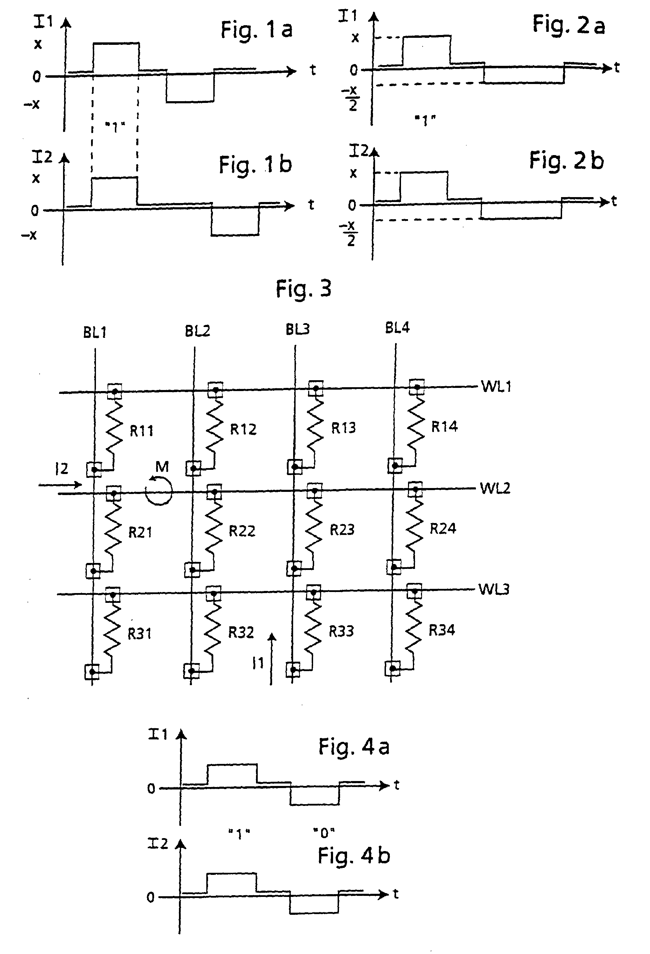

Fig. 3 zeigt den Aufbau eines herkömmlichen MRAMs. Dieser besteht aus Wortleitungen WL1, WL2, WL3, ... und Bitleitungen BL1, BL2, BL3, BL4, ..., welche die Wortleitungen WL1, WL2, WL3, ... im wesentlichen senkrecht kreuzen. An den Kreuzungsstellen zwischen den Wortleitungen WL1, WL2, WL3, ... und den Bitleitungen BL1, BL2, BL3, BL4, ... liegen Speicherzellen, die jeweils durch einen Widerstand R11, R12, ..., R33, R34, allgemein Rij, angedeutet sind.

Dieser Widerstand Rij repräsentiert die Strecke eines Tunnelstromes, der zwischen einer Wortleitung, beispielsweise der Wortleitung WL2, und einer Bitleitung, beispielsweise der Bitleitung BL3, fließt, wenn eine Spannungsdifferenz zwischen dieser Wortleitung WL2 und dieser Bitleitung BL3 vorliegt. Abhängig von einem in die Speicherzelle geschriebenen Magnetfeld nimmt dann dieser Tunnelstrom einen größeren oder kleineren Wert an. Mit anderen Worten, die Speicherzelle kann als Binärwiderstand aufgefaßt werden, der mit einem größeren oder kleineren Widerstandswert programmiert ist. Diesen beiden Widerstandswerten kann dann die Informationseinheit "1" oder "0" zugeordnet werden.

Das Programmieren einer Speicherzelle erfolgt also durch Anlegen eines Magnetfeldes. Um nun eine Speicherzelle auf einen Wert "0" oder "1" zu programmieren, muß das Magnetfeld gewisse Schwellenwerte überschreiten. Dabei ist zu beachten, daß die Speicherzelle eine magnetische Hysterese hat.

Wie in Fig. 3 angedeutet ist, bewirkt beispielsweise ein in der Wortleitung WL2 fließender Gleichstrom I2 ein Magnetfeld M um diese Wortleitung WL2. Die Richtung des Magnetfeldes M ist dabei umgekehrt, wenn der Strom I2 in umgekehrter Richtung fließt. Die Richtung des Magnetfeldes M gibt nun an, ob eine "1" oder eine "0" in eine Speicherzelle eingeschrieben wird.

Es sei nun angenommen, daß der Strom I2 in der Wortleitung WL2 die Informationsinhalt "1" bedeutet. Alle Speicherzellen, die mit der Wortleitung WL2 verbunden sind, also die Speicherzellen mit den Widerständen R21, R22, R23 und R24 sind durch den Strom I2 mit dem Magnetfeld M beaufschlagt. Die Hysterese der Speicherzellen mit den Widerständen R21, R22, R23, R24 bewirkt nun, daß das Magnetfeld M allein noch nicht ausreichend stark ist, um alle diese Speicherzellen aus einem "0"-Zustand in einen "1"-Zustand zu bringen. Vielmehr muß zusätzlich noch eine Bitleitung, beispielsweise die Bitleitung BL3, mit einem Strom I1 angesteuert werden, um an der Schnittstelle der Bitleitung BL3 mit der Wortleitung WL2 ein Magnetfeld zu erzeugen, das durch Überlagerung der durch die Ströme I1 und I2 erzeugten Magnetfelder ausreichend stark ist, um an der Schnittstelle, also im Widerstand R23, den "0"-Zustand in einen "1"-Zustand zu überführen. Mit anderen Worten, durch Ansteuerung von ausgewählten Wortleitungen WLi und ausgewählten Bitleitungen BLj ist es möglich, die Speicherzellen an den Schnittstellen dieser Wort- und Bitleitungen - abhängig von der Richtung des durch die jeweiligen Ströme erzeugten Magnetfeldes - in einen "0"- oder "1"-Zustand zu programmieren.

Da nun die Ströme I1 und I2, die zum Programmieren der Speicherzellen angelegt sind, Gleichströme sind, tritt infolge des Programmierens eine Elektromigration auf, wenn hauptsächlich immer das gleiche Signal, also beispielsweise eine "1", in die Speicherzellen geschrieben wird. Diese Elektromigration durch die im mA-Bereich liegenden Speicherströme bedeutet letztlich einen Materialtransport, der sogar zu einer Zerstörung der entsprechenden metallischen Leitungen führen kann. Damit wird die Lebensdauer von MRAMs in unerwünschter Weise eingeschränkt.

Anhand der Figuren 4a und 4b soll die obige Problematik der Elektromigration nochmals verdeutlicht werden. In den Figuren 4a und 4b sind die Programmierströme I1 und I2 in Abhängigkeit von der Zeit t aufgetragen. Zum Einschreiben einer "1" in die Speicherzelle mit dem Widerstand R23 werden Signale positiver Polarität für die Ströme I1 und I2 verwendet, während Signale negativer Polarität das Einschreiben einer "0" in diese Speicherzelle bewirken. Werden nun in die Speicherzelle mit dem Widerstand R23 ständig "1" oder ständig "0" eingeschrieben, so fließen die Ströme I1 und I2 immer in der gleichen Richtung durch die Bitleitung BL3 bzw. durch die Wortleitung WL2, was zu der Elektromigration führt. Nur wenn abwechselnd nacheinander "0" und "1" in die Speicherzelle mit dem Widerstand R23 eingeschrieben werden, tritt ein Materialtransport in wechselnder Richtung auf, was die Zerstörung der entsprechenden Leitungen BL3 bzw. WL2 verhindert. Da es aber zahlreiche Anwendungsfälle gibt, bei denen immer der gleiche Speicherinhalt, also ständig "0" oder ständig "1" in eine Speicherzelle eingeschrieben wird, muß davon ausgegangen werden, daß die Elektromigration durch den Materialtransport zu einer Zerstörung der Leitungen führt.

Bekanntlich tritt bei Anlegung eines Wechselstromes praktische keine Elektromigration auf. Ein Wechselstrom ist aber bei MRAMs nicht einsetzbar, da durch ihn keine Speicherinhalte definierbar sind.

Es ist daher Aufgabe der vorliegenden Erfindung, ein Verfahren zur Verhinderung von Elektromigration in einem MRAM anzugeben, um so eine Zerstörung der Leitungen des MRAMs zu verhindert.

Diese Aufgabe wird bei einem Verfahren der eingangs genannten Art erfindungsgemäß dadurch gelöst, daß nach dem Programmierschritt durch die mit dem Gleichstromsignal beaufschlagten Wort- und Bitleitungen ein zu dem Gleichstromsignal in der Polarität entgegengesetztes weiteres Gleichstromsignal geschickt wird. Dieses weitere Gleichstromsignal wird den zu dem ausgewählten Widerstand gehörenden Wort- und Bitleitungen aber zeitlich versetzt oder mit gegenüber dem Gleichstromsignal verringerter Amplitude und längerer Dauer zugeführt.

Durch diese zeitliche Versetzung der weiteren Gleichstromsignale in den Wort- und Bitleitungen und durch die verringerte Amplitude des weiteren Gleichstromsignales wird erreicht, daß das Magnetfeld an den Schnittstellen der Wort- und Bitleitungen, also in den Speicherzellen, nicht den Schwellenwert überschreitet, der zu einem Einschreiben von Information in die Zelle und damit zu einer Zerstörung der bereits eingeschriebenen Information führt.

Nachfolgend wird die Erfindung anhand der Zeichnungen näher erläutert. Es zeigen:
- Fig. 1a und 1b: Signaldiagramme zur Erläuterung eines ersten Ausführungsbeispiels des erfindungsgemäßen Verfahrens,
- Fig. 2a und 2b: Signaldiagramme zur Erläuterung eines zweiten Ausführungsbeispiels des erfindungsgemäßen Verfahrens,
- Fig. 3: den Aufbau eines MRAMs,
- Fig. 4a und 4b: Signaldiagramme zur Erläuterung des Einschreibens einer "1" bzw. einer "0" in eine Speicherzelle bei dem MRAM von Fig. 3.

Die Figuren 3, 4a und 4b sind bereits eingangs erläutert worden.

Die Figuren 1a und 1b zeigen - ähnlich wie die Figuren 4a und 4b - jeweils in ihrer linken Hälfte das Einschreiben einer "1" durch gleichzeitiges Anlegen der Ströme I1 und I2 an die Bitleitung BL3 bzw. an die Wortleitung WL2 (vgl. Fig. 3). Soll anstelle einer "1" eine "0" eingeschrieben werden, so wird die Polarität der Ströme I1 bzw. I2 von +x nach -x verändert.

Um nun eine Elektromigration bzw. einen Materialtransport zu kompensieren, werden bei dem erfindungsgemäßen Verfahren nach dem Programmierschritt, bei dem die "1" in die Speicherzelle mit dem Widerstand R23 eingeschrieben wurde, Signale entgegengesetzter Polarität zeitlich versetzt zueinander an die Bitleitung BL3 bzw. an die Wortleitung WL2 angelegt. Durch diese zeitliche Versetzung der Signale mit der Amplitude -x wird sichergestellt, daß in der Speicherzelle mit dem Widerstand R23 der für ein Einschreiben notwendige Schwellenwert des Magnetfeldes nicht überschritten wird. Das heißt, die in der Speicherzelle gespeicherte Information, nämlich die "1", bleibt vollständig erhalten und wird nicht durch eine "0" ersetzt, was geschehen würde, wenn die zeitliche Versetzung zwischen den Signalen mit der Amplitude -x in der Bitleitung BL3 bzw. in der Wortleitung WL2 nicht vorhanden wäre.

Die Figuren 2a und 2b zeigen ein weiteres Ausführungsbeispiel des erfindungsgemäßen Verfahrens, bei dem nach dem Einschreiben einer "1" ein Impuls mit halber Amplitude und entgegengesetzter Polarität für eine längere Zeitdauer an die Bit- und Wortleitungen der gerade mit der "1" beschriebenen Speicherzelle angelegt wird. Durch die halbe Amplitude mit dem Wert - x/2 des Schreibimpulses mit dem Wert x wird eine Zerstörung der eingeschriebenen Information sicher vermieden. Gleichzeitig wird aber die Elektromigration infolge der längeren Zeitdauer dieses Impulses mit halber Amplitude kompensiert. Bevorzugt wird für die Zeitdauer des Impulses mit halber Amplitude etwa die doppelte Zeitdauer des Schreibimpulses zum Einschreiben der Information "1" herangezogen.

Bei dem Ausführungsbeispiel der Figuren 2a und 2b wird der die Elektromigration kompensierende Impuls halber Amplitude zur gleichen Zeit an die Bit- und Wortleitungen angelegt. Selbstverständlich ist es aber auch möglich, zusätzlich noch eine zeitliche Versetzung - ähnlich wie im Beispiel der Figuren 1a und 1b - vorzusehen.

In dem Ausführungsbeispiel der Figuren 2a und 2b hat der das Schreibsignal kompensierende Impuls die halbe Amplitude des Schreibsignales. Selbstverständlich sind aber auch andere Werte für dieses Kompensationssignal möglich. Entscheidend ist lediglich, daß der Schwellenwert zum Einschreiben von Information bei gleichzeitigem Anlegen des Kompensationssignales an die Bitleitung und die Wortleitung nicht überschritten wird.

## Patentansprüche

1. Verfahren zur Verhinderung von Elektromigration in einem MRAM aus Wortleitungen (WL), die Wortleitungen (WL) kreuzenden Bitleitungen (BL) und an den Kreuzungspunkten zwischen den Wortleitungen (WL) und den Bitleitungen (BL) vorgesehenen Widerständen (R), deren Widerstandswert durch ein Magnetfeld derart beeinflußbar ist, daß dieser zwei logischen Zuständen "1" oder "0" zugeordnet ist, indem in einem Programmierschritt durch die zu einem ausgewählten Widerstand gehörenden Wort- und Bitleitungen gleichzeitig jeweils ein zusammen das Magnetfeld erzeugendes Gleichstromsignal geschickt wird,
**dadurch gekennzeichnet,**
**daß** nach dem Programmierschritt durch die mit dem Gleichstromsignal beaufschlagten Wort- und Bitleitungen (WL, BL) ein zu dem Gleichstromsignal in der Polarität entgegengesetztes weiteres Gleichstromsignal geschickt wird.

2. Verfahren nach Anspruch 1,
**dadurch gekennzeichnet,**
**daß** das weitere Gleichstromsignal den zu dem ausgewählten Widerstand gehörenden Wort- und Bitleitungen zeitlich versetzt zugeführt wird.

3. Verfahren nach Anspruch 1 oder 2,
**dadurch gekennzeichnet,**
**daß** das weitere Gleichstromsignal den zu dem ausgewählten Widerstand gehörenden Wort- und Bitleitungen mit gegenüber dem Gleichstromsignal verringerter Amplitude und längerer Zeitdauer zugeführt wird.

4. Verfahren nach Anspruch 3,
**dadurch gekennzeichnet,**
**daß** das weitere Gleichstromsignal etwa die halbe Amplitude und die doppelte Zeitdauer des Gleichstromsignales hat.
